# EUROPEAN PATENT SPECIFICATION

(11) **EP 2 346 092 B1**
(45) Date of publication and mention of the grant of the patent: **11.12.2019**
(21) Application number: 09820245.0
(22) Date of filing: 12.10.2009
(51) Int. Cl.: H01L 31/0216, H01L 31/054, H02S 40/22, H02S 20/26, H02S 40/20, H01L 31/048

(54) **PHOTOELECTRIC MODULE**
FOTOELEKTRISCHES MODUL
MODULE PHOTOÉLECTRIQUE

(30) Priority: 13.10.2008 CN 200820134895 U
(43) Date of publication of application: 20.07.2011
(73) Proprietor: National Taiwan University of Science and Technology, Taipei (TW)
(72) Inventor: YOUNG, Chin-Huai, Taipei (TW)
(74) Representative: Viering, Jentschura & Partner mbB Patent- und Rechtsanwälte
(86) International application number: PCT/CN2009/074405
(87) International publication number: WO 2010/043169

(56) References cited:
- EP-A2- 0 788 171
- WO-A1-00/46860
- WO-A1-2008/125264
- WO-A2-98/59122
- CN-A- 101 140 958
- CN-A- 101 262 020
- CN-Y- 201 084 738
- CN-Y- 201 122 603
- CN-Y- 201 285 767
- JP-A- 2000 183 375
- JP-A- 2008 016 595
- US-A1- 2007 277 810
- US-B1- 6 515 217
- US-B1- 6 515 217

## Description

### BACKGROUND OF THE INVENTION

### Technical Field

The present invention relates to a photovoltaic module having a solar panel, and more particularly to a photovoltaic module having a solar panel, a reflective insulating element, and a plate.

### Related Art

Along with the requirements for power saving and environment protection, solar energy generation has become a hotspot technology of new energy sources, and many products such as water heaters and small household appliances have already used the solar energy as an assistant or main power supply.

The solar energy is renewable, clean, and safe, cannot be monopolized, and will not cause any pollution. With these advantages, the solar energy is indeed a trouble-free new generation energy source.

Among the techniques for converting the solar energy into electric energy, solar panels are most commonly used. The solar panel includes a plurality of photoelectric semiconductor sheets capable of generating power by directly using sunlight based on the principle of adding some impurities into a highly pure semiconductor material to make the semiconductor material have different properties. For example, the semiconductor with boron can form a P-type semiconductor, and the semiconductor with phosphor can form an N-type semiconductor. After the P-type semiconductor is combined with the N-type semiconductor, when the sunlight is incident on the semiconductor, electrons in the N-type semiconductor are knocked out, and immediately jump into the P-type semiconductor and cannot exit, thus forming a unilateral conduction. A junction between the P-type semiconductor and the N-type semiconductor has dispersed electrons, a large amount of free electrons are thus generated, and the movement of the electrons generates a current, that is to say, a potential difference is generated on the junction.

Meanwhile, early solar panels are mostly applied in small electronic products such as calculators and watches. Along with the progress of the semiconductor process, the size of current solar panels is much larger than that of the conventional ones; as a result, a current solar panel has a larger light receiving area, and thus can output more power. Therefore, the development trend of the solar panels is the large-size technology.

Moreover, although many buildings or vehicles have adopted the solar panels as assistant power sources, for example, the solar panels are mounted on wall faces of buildings or on non-buildings (such as roof of a vehicle), the power generating efficiency of a solar panel is still limited by the area thereof, and thus the power generating efficiency cannot be effectively improved under the same area and the same amount of light.

Further, when the existing solar panel is combined with the building or vehicle, the solar panel has to be mounted on a site with sufficient sunlight, such as a surface exposed to the sun of a building or non-building, or a vehicle roof, so as to maintain the stability of power generation. However, under long-time irradiation of sunlight, heat energy tends to enter the building or the vehicle through radiation or conduction, thus causing raised temperature and inconvenience in life.

In order to improve the power generating efficiency of the solar panel, another solar panel module receiving light with double faces is thus developed. The solar panel module includes a double-face solar panel. The solar panel module receiving light with double faces is disposed obliquely, such that an upper solar panel has a surface facing upwards to directly absorb the incident light of the solar energy. A reflective plate is further disposed on a horizontal plane at a negative position of the solar panel module, such that the reflective plate reflects the sunlight to a lower solar panel, thus achieving the purpose of receiving light with double faces.

However, the solar panel module receiving light with double faces needs a large reflection space, thus having a large volume and occupying a large area. In afternoons, the negative position of the solar panel cannot provide reflected light to the solar panel, so the solar panel module is limited in time.

ROC Patent Publication No. 536063 disclosed a solar photovoltaic module, which includes a solar panel receiving light with double faces and a backlight module disposed at a negative position
of the solar panel module. A side edge of the backlight module protrudes and surrounds the periphery of the solar panel module, such that the protruded part on the side edge of the backlight module gathers light to provide a light source to be absorbed by the solar panel of the solar energy module, thus achieving the characteristic of absorbing light with double faces.

The technique of disposing light-gathering protrusion on the periphery of the backlight module can provide the sunlight to the solar panel again; however, the height of the protrusion is limited by thickness of the whole solar photovoltaic module, so the light source provided to the solar panel again is limited, and the power generating efficiency cannot be improved effectively. Further, the photovoltaic module currently is required to be environment-friendly and power saving, and must be light and thin as well; however, the solar photovoltaic module has to additionally dispose the light-gathering protrusion, which not only increases the overall thickness and lacks the characteristics of light and thin, but also is inconvenient in assembly and manufacturing.

In addition, ROC Patent Publication No. M325607 disclosed a solar panel device having wing-type flat mirrors controlled by a single chip. The solar panel is adjusted through a sunlight tracing device to enable the solar panel to be approximately perpendicular to the sunlight. Meanwhile, flat mirrors capable of changing inclined angles are disposed on long side edges of the solar panel, such that the light not perpendicular to the solar panel can be reflected by the flat mirrors, and perpendicular components of the light after being reflected can be further used by the solar panel, thereby improving the photovoltaic conversion energy of the solar panel.

In this patent, the solar panel must be adjusted and flat mirrors must be additionally disposed, so the structure is highly complicated and thus has a high cost. Moreover, the solar panels disposed fixedly are difficult to move. In other words, this patent cannot be applied to the existing buildings or non-buildings and has to be rearranged.

Some further devices are known from WO 2008/125264 A1, from JP 2008 016595 A, and from US 2007/277810 A1.

In view of the above, the prior art has many defects that need to be eliminated by persons in the art.

### SUMMARY

According to the present invention, a photovoltaic module as defined in claim 1 is provided. The dependent claims show some examples of such a module.

Accordingly, the inventor designs a new photovoltaic module through fine researches based on several years' experiences in this field.

The present invention is directed to a photovoltaic module capable of improving power generating efficiency and having a heat insulation function.

The present invention is further directed to a photovoltaic module having a wide application range.

In order to achieve the above objectives and other objectives, the present invention provides a photovoltaic module including a solar panel, a reflective insulating element, and a plate. The reflective insulating element reflects the sunlight, and the reflected sunlight passes through the solar panel, which results in an enhancement of electro-optical effects occurred in the solar panel. Therefore, the amount of the sunlight that can be used by the solar panel to perform the photovoltaic conversion for generating the electric energy is increased.

The reflective insulating element is disposed between the plate and the solar panel. The plate is made of glass. The photovoltaic module includes a frame accommodating the plate, the reflective insulating element, and the solar panel. The frame can be directly mounted to a window, a skylight, a wall, and the like of an ordinary building, thus achieving the practicability of convenient construction and convey.

At the same time, heat energy, such as heat radiation, generated by light irradiation can be partially reflected or insulated by the reflective insulating element, such that the heat energy will not all pass through the photovoltaic module, thus achieving the effect of heat insulation.

### BRIEF DESCRIPTION OF THE DRAWINGS

The present invention will become more fully understood from the detailed description given herein below for illustration only, and thus are not limitative of the present invention, and wherein:
FIG. 1 is a three-dimensional view of a first example of a photovoltaic module not forming part of the present invention;
FIG. 2 is a side view of the first example of a photovoltaic module not forming part of the present invention;
FIG. 3 is a three-dimensional view of a second example of a photovoltaic module not forming part of the present invention;
FIG. 4 is a three-dimensional sectional view of a third example of a photovoltaic module not forming part of the present invention;
FIG. 5 is a sectional view of a photovoltaic module, wherein Fig. 5 does not show all features of claim 1 and does not form part of the present invention;
FIG. 6 is a sectional view of an embodiment of a photovoltaic module according to the present invention;
FIG. 7 is a sectional view of a photovoltaic module, wherein Fig. 7 does not show all features of claim 1 and does not form part of the invention;
FIG. 8 is a schematic view of the usage of the third example of a photovoltaic module;
FIG. 9 is another schematic view of the usage of an exemplified photovoltaic module; and
FIG. 10 is still another schematic view of the usage of an exemplified photovoltaic module;

### DETAILED DESCRIPTION

In order to make the examiners to clearly understand the content of the present invention, the present invention is described below with reference to the accompanying drawings in detail.

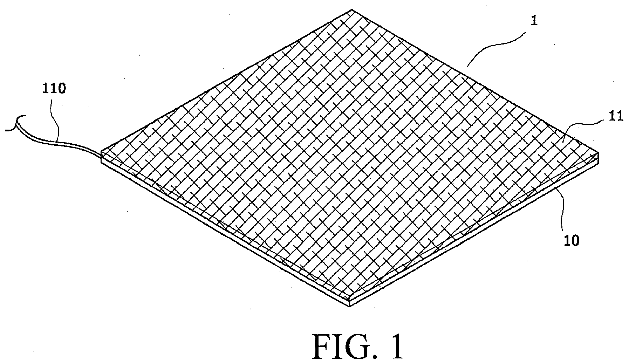

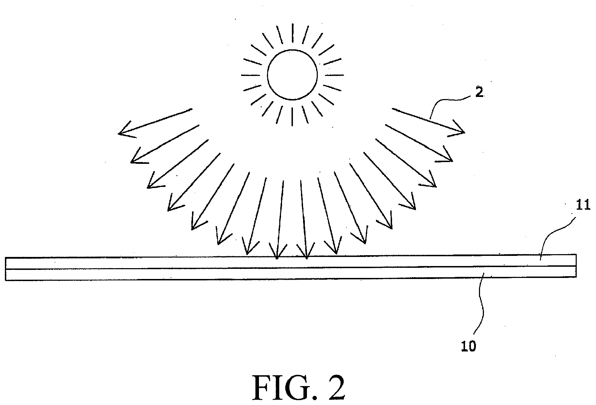

FIGs. 1 and 2 are a three-dimensional view and a side view of a first example of a photovoltaic module not forming part of the present invention respectively. As shown in FIGs. 1 and 2, a photovoltaic module 1 of this example includes a reflective insulating element 10 and a solar panel 11.

The reflective insulating element 10 may be a heat reflective film, a heat reflective sheet, or other equivalent elements capable of reflecting light rays passing through the solar panel 11. That is, as long as the element can reflect the heat radiation and light rays generated by sunlight irradiation to achieve the function of heat insulation, the element is applicable to the present invention. Further, the reflective insulating element 10 may be transmissive, semi-transmissive, or having different transmittance. For example, when being disposed on a roof, a wall, and other building material surfaces of a building, the reflective insulating element 10 can be a non-transmissive element, and when being disposed on plates such as glass and skylight, or other non-buildings, the reflective insulating element 10 can be a non-transmissive or semi-transmissive element.

In this example, for example, the reflective insulating element 10 is a heat insulation film, and more particularly, the reflective insulating element 10 may be a heat-insulation film for insulating light/heat sources, a multi-layer heat-insulation film patch, a polyester (PET) thin-film with a proper thickness, or other equivalent film layers. As for the multi-layer heat-insulation film patch, multiple layers of base films are combined with multiple light resistant layers as well as anti-wear layers, so as to achieve a desired heat insulation effect while considering the light transmittance of visible light, and selectively improve anti-infrared/ultraviolet (IR/UV), or anti-wear performance of the multi-layer heat-insulation film patch. As for the PET thin film, a metal layer made of Ni, Ag, Al, Cr, or the like may be coated on a surface of the PET thin film, or a dyed layer containing organic dyes may be added to the surface of the PET thin film, thus enabling the PET thin film to have desired anti-IR/UV capability.

It should be noted that, the reflective insulating element 10 in this example is an independent component, and can be bonded to the surface of the solar panel 11 with an adhesive, optical adhesive, or optical adhesive tape; however, in other embodiments, the reflective insulating element 10 can also be a film layer disposed on the solar panel 11 or the plate 12 integrally. For example, a coating having a moderate reflectivity, a coating having a high reflectivity, and a coating having a low reflectivity are coated sequentially on a surface of the solar panel 11, thus forming the reflective insulating element 10. Meanwhile, the reflective insulating element 10 is not limited to the heat-insulation film, multi-layer heat-insulation film patch, and PET thin film, and may also be an optical heat-insulation film with a nano structure or other equivalent elements having reflection and heat insulation functions.

The solar panel 11 can be an amorphous silicon solar panel, a monocrystalline silicon solar panel, a polysilicon solar panel, or other relevant solar panels manufactured through a silicon wafer and semiconductor process. Alternatively, the solar panel 11 may be a thin-film solar panel made of a material selected from a group consisting of microcrystalline silicon (µc-Si)), copper indium diselenide (CIS), copper indium gallium diselenide (CIGS), GaAs multijuction, dye-sensitized solar panel, and organic/polymer solar panels. In other words, the solar panel 11 can be those described in this example or those in the other types. Because the types and structures of the solar panels are all well known, they are not described herein.

In this example, for example, the solar panel 11 has the properties of high transmittance and low reflectivity. When light rays such as sunlight pass through the solar panel 11, the solar panel 11 performs the photovoltaic conversion to generate the electric energy. The electric energy can be transmitted outwards through a lead 110 connected to the solar panel 11. The solar panel 11 is the conventional art, so it is not described in detail here.

With the above structure, when an incident sunlight 2 contacts with the solar panel 11, the solar panel 11 first performs the photovoltaic conversion to generate the electric energy; when the incident sunlight 2 passes through the solar panel 11 to irradiate the reflective insulating element 10, the reflective insulating element 10 reflects a part of the incident sunlight 2, and the reflected sunlight 2 contacts with and passes through the solar panel 11. As such, when the solar panel 11 performs the photovoltaic conversion, in addition to the incident sunlight 2, the reflected sunlight 2 reflected by the reflective insulating element 10 can also serve as the light energy source for photovoltaic conversion, thus improving the power generating efficiency of the photovoltaic conversion.

Further, when the light rays such as sunlight continuously irradiate the photovoltaic module 1 in this example, the reflective insulating element 10 can reflect the incident sunlight 2 as well as reflect or insulate the heat radiation, thus effectively insulating the heat energy.

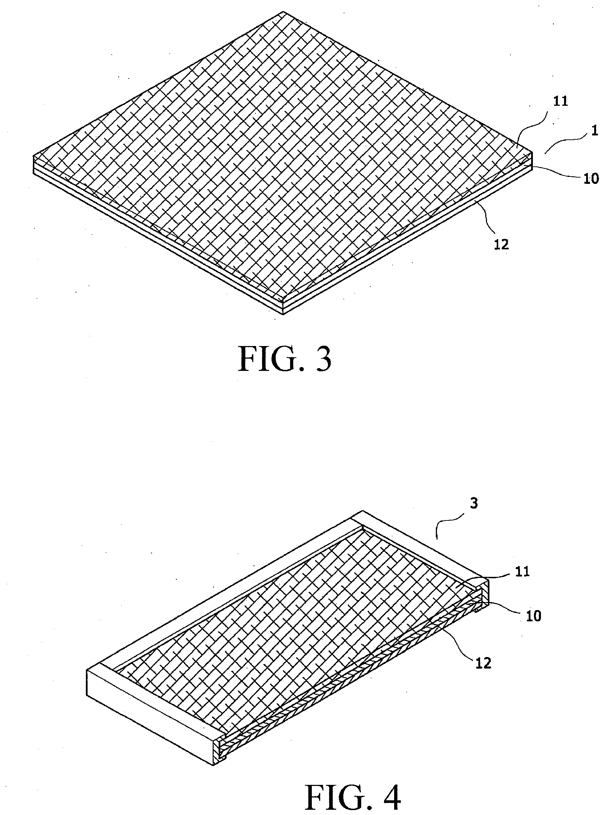

FIG. 3 is a three-dimensional view of a second example of a photovoltaic module not forming part of the invention. Referring to FIG. 3, the photovoltaic module 1 of this example further includes a plate 12. The reflective insulating element 10 and the plate 12 are disposed at one side of the solar panel 11 in sequence. The plate 12 is selected according to the sites where the plate 12 is used or requirements in use. And the plate 12 in this example can be, for example, glass used on window, skylight, show window, and the like. Definitely, in other examples, the plate 12 can also be a building material used on the wall, roof, and drip of a building. That is to say, the plate 12 can be a fixing member for fixing the reflective insulating element 10 and the solar panel 11. Moreover, the reflective insulating element 10 and the solar panel 11 are the same as those shown in FIGs. 1 and 2, and thus are not described again here.

In this example, the reflective insulating element 10, the solar panel 11, and the plate 12 can be bonded with the adhesive, the optical adhesive, or the optical adhesive tape, so as to form the photovoltaic module 1. Alternatively, the reflective insulating element 10 is directly formed on a surface of the plate 12 or on a surface of the solar panel 11 integrally.

In this example, similar to the first example, the reflective insulating element 10 may adopt the heat-insulation film, the multi-layer heat-insulation film patch, and the PET thin film. Alternatively, coatings with different reflectivity are coated on the solar panel 11 or the plate 12 to serve as the reflective insulating element 10, for example, on glass of a show window, a lens, and the like. Alternatively, the reflective insulating element 10 may use coated glass such as low-E glass. The low-E glass has high transparency, low glare, and a preferred radiation/heat insulation effect, and can be classified into hard low-E glass, soft low-E glass, and PET low-E glass. The structure and principle of the low-E glass belong to the conventional art, so they are not described again here. In addition, using heat-insulation film with high reflectivity is able to increase the efficiency of power generation as well as improve the definition of photovoltaic module 1.

Thereby, the photovoltaic module 1 of this example can be combined with the building material for ordinary building, the glass, or other plates, and when the light rays such as sunlight irradiate on the photovoltaic module 1, the power generating efficiency of the solar panel 11 during the photovoltaic conversion is improved and the solar panel 11 also has a heat insulation function.

FIG. 4 is a three-dimensional sectional view of a third example of a photovoltaic module not forming part of the present invention. Referring to FIG. 4, the photovoltaic module 1 in this example further includes a frame 3. The frame 3 can be a frame of a window, a window frame of a vehicle skylight, or a frame in the building. After the reflective insulating element 10, the solar panel 11 and the plate 12 are bonded with the adhesive, the optical adhesive, or the optical adhesive tape to form the photovoltaic module 1, they can be assembled in the frame 3. Thereby, the photovoltaic module 1 can be directly mounted on a wall surface of an ordinary building or non-building, and has the practicability of fast installation and the convenience of conveying.

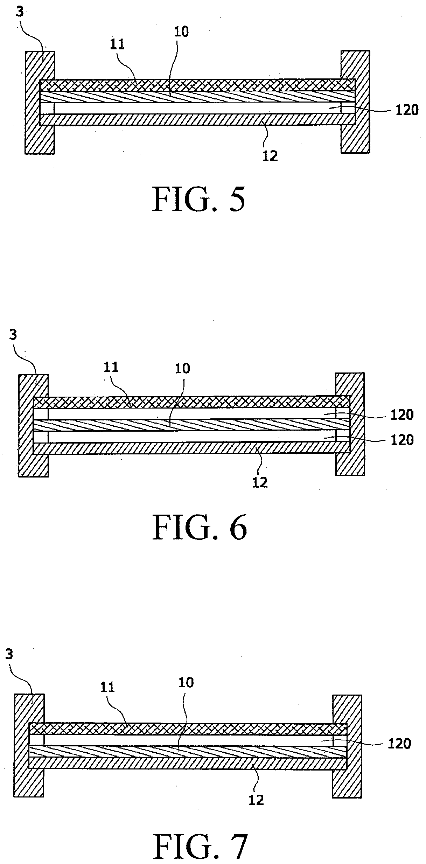

Referring to FIG. 5, which shows an example of a photovoltaic module not forming part of the present invention, the structure of FIG. 4 is changed, such that a gap is formed between the reflective insulating element 10 and the plate 12, so as to form a hollow layer 120. Alternatively, referring to FIG. 6, which shows a three-dimensional sectional view of an embodiment of a photovoltaic module according to the present invention, two gaps are disposed between the solar panel 11 and the reflective insulating element 10 as well as between the plate 12 and the reflective insulating element 10 individually, forming two hollow layers to obstruct heat conduction. That is, the reflective insulating element 10, the solar panel 11, and the plate 12 are disposed separately, thus forming two hollow layers 120. Alternatively, referring to FIG. 7, which shows an example of a photovoltaic module not forming part of the present invention, a gap is formed between the reflective insulating element 10 and the solar panel 11, so as to form a hollow layer 120. As such, when sunlight irradiates the solar panel 11, besides that the reflective insulating element 10 reflects/insulates the heat radiation, the hollow layer 120 further obstructs the heat conduction between the reflective insulating element 10, the solar panel 11, and the plate 12, thus improving the heat insulation effect.

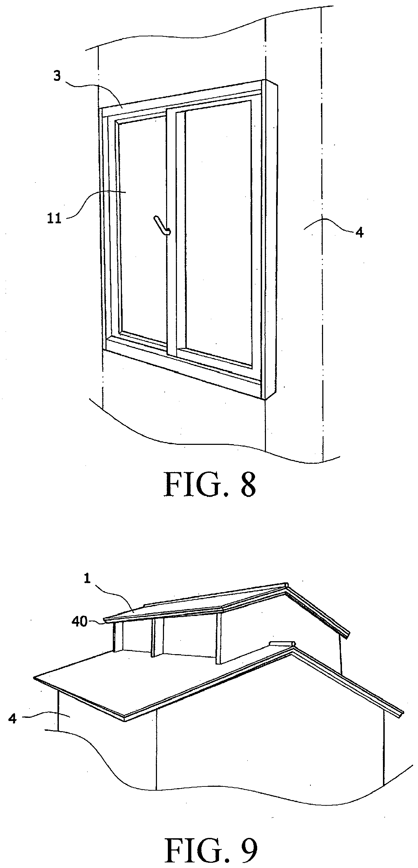

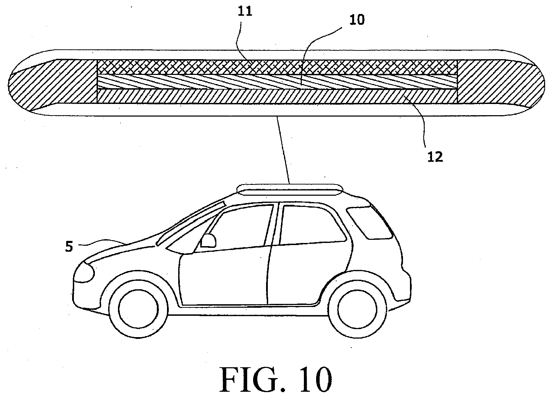

FIGs. 8 and 9 are schematic views of using examples of a photovoltaic module. Referring to FIG. 8, the frame 3 is disposed on the wall surface of a building 4, and the reflective insulating element 10, the solar panel 11, and the plate 12 (only the solar panel 11 is shown in FIG. 8) are disposed in the frame 3, as shown in the third example. Referring to FIG. 9, a schematic view of another using state of an example of a photovoltaic module is shown. The building 4 has a roof 40, and the photovoltaic module 1 is disposed on a surface of the roof 40. Moreover, the photovoltaic module 1 is disposed on the roof 40, and if it is not intended that light such as sunlight enters the building 4, the reflective insulating element 10 can be non-transmissive. Referring to FIG. 10, a schematic view of another using of an example of a photovoltaic module is shown. A skylight is provided on a vehicle 5, and the photovoltaic module 1 in the second example can be disposed on the skylight. Alternatively, the photovoltaic module in the third example may be selected to be disposed on the skylight, or the photovoltaic modules in the different examples described above may be directly disposed on the vehicle roof.

Referring to all the accompanying drawings, compared with the prior art, the present invention has the following efficacies. The solar panel 11 performs the photovoltaic conversion to generate the electric energy, in addition, reflects the sunlight. The light reflected by the reflective insulating element 10 performs the photovoltaic conversion again to generate the electric energy. Therefore, different from the defect of the prior art that the conventional solar panel has, the present invention apparently improves the efficiency of photovoltaic conversion without changing the scale of the solar panel 11.

The reflective insulating element 10 of the photovoltaic module 1 can reflect or insulate the heat radiation and reflects part of sunlight. Compared with the defect of the prior art that the conventional solar panel easily causes temperature rise in the building or vehicle, the present invention further has the practicability of heat insulation.

## Claims

1. A photovoltaic module (1), comprising a solar panel (11), wherein:
a reflective insulating element (10) and a plate (12) are disposed at one side of the solar panel (11) in sequence, the reflective insulating element is located between the solar panel and the plate such that the reflective insulating element (10) reflects part of sunlight which passes through the solar panel (11), resulting in that the reflected sunlight passes through the solar panel (11) again, and the plate is made of glass;
a frame accommodating the plate, the reflective insulating element, and the solar panel; and
one gap disposed between the plate (12) and the reflective insulating element (10) and another gap disposed between the solar panel (11) and the reflective insulating element (10), forming two hollow layers (120).

2. The photovoltaic module (1) according to claim 1, wherein the reflective insulating element (10) is selected from a group consisting of a heat-insulation film, a multi-layer heat-insulation film patch, and a polyester thin film.

3. The photovoltaic module (1) according to claim 1, wherein the solar panel (11) is selected from a group consisting of an amorphous silicon solar panel, a monocrystalline silicon solar panel, a polysilicon solar panel, a thin-film solar panel, and a solar panel manufactured with a silicon wafer and semiconductor process.

4. The photovoltaic module (1) according to claim 1, wherein the solar panel (11) is a thin-film solar panel made of a material selected from a group consisting of microcrystalline silicon , copper indium diselenide , copper indium gallium diselenide, GaAs multi-junction, dye-sensitized solar panel, and organic/polymer solar panels.

## Patentansprüche

1. Ein Photovoltaikmodul (1), das ein Solarpanel (11) aufweist, wobei:
ein reflektierender Isolierkörper (10) und eine Platte (12) auf einer Seite des Solarpanels (11) der Reihe nach angeordnet sind, und
wobei der reflektierende Isolierkörper zwischen dem Solarpanel und der Platte positioniert, so dass der reflektierende Isolierkörper (10) einen Teil des Sonnenlichts, welcher durch das Solarpanel (11) hindurchgeht, derart reflektiert, dass das reflektierte Sonnenlicht wieder durch das Solarpanel (11) hindurchgeht, und
wobei die Platte aus Glas besteht;
ein Rahmen die Platte, den reflektierenden Isolierkörper und das Solarpanel aufnimmt; und
sich ein Spalt zwischen der Platte (12) und dem reflektierenden Isolierkörper (10) befindet, und sich ein anderer Spalt zwischen dem Solarpanel (11) und dem reflektierenden Isolierkörper (10) befindet, so dass zwei Hohlschichten (120) gebildet werden.

2. Das Photovoltaikmodul (1) gemäß Anspruch 1, wobei der reflektierende Isolierkörper (10) aus einer Gruppe ausgesucht ist, welche eine Wärmeisolierfolie, ein mehrschichtiges Wärmeisolierfolien-Patch und eine Dünnschicht-Polyesterfolie umfasst.

3. Das Photovoltaikmodul (1) gemäß Anspruch 1, wobei das Solarpanel (11) aus einer Gruppe ausgesucht ist, welche ein Amorphes-Silizium-Solarpanel, eine Monokristallines-Silizium-Solarpanel, eine Poly-Silizium-Solarpanel, ein Dünnschicht-Solarpanel und ein Solarpanel, das mit einem Silizium-Wafer und einem Halbleiterverfahren hergestellt ist, umfasst.

4. Das Photovoltaikmodul (1) gemäß Anspruch 1, wobei das Solarpanel (11) ein Dünnschicht-Solarpanel ist, das aus einem der Materialien hergestellt ist, das aus einer Gruppe ausgewählt ist, welche mikrokristallines Silizium, Kupfer-Indium-Diselenid, Kupfer-Indium-Gallium-Diselenid, GaAs (Galliumarsenid)-Mehrfachsolarzellen, Farbstoffsolarzelle und organische/ Polymer-Solarpanele umfasst.

## Revendications

1. Module photovoltaïque (1), comprenant un panneau solaire (11), dans lequel :
un élément isolant réfléchissant (10) et une plaque (12) sont disposés à la suite sur un côté du panneau solaire (11), l'élément isolant réfléchissant est situé entre le panneau solaire et la plaque de telle sorte que l'élément isolant réfléchissant (10) réfléchit une partie de la lumière du soleil qui passe à travers le panneau solaire (11), ce qui amène la lumière du soleil réfléchie à passer une nouvelle fois à travers le panneau solaire (11), et la plaque est en verre ;
un châssis recevant la plaque, l'élément isolant réfléchissant et le panneau solaire ; et
un premier espace disposé entre la plaque (12) et l'élément isolant réfléchissant (10) et un autre espace disposé entre le panneau solaire (11) et l'élément isolant réfléchissant (10), formant deux couches creuses (120).

2. Module photovoltaïque (1) selon la revendication 1, dans lequel l'élément isolant réfléchissant (10) est choisi dans un groupe constitué d'un film d'isolation thermique, d'une pièce de film d'isolation thermique multicouche, et d'un film mince de polyester.

3. Module photovoltaïque (1) selon la revendication 1, dans lequel le panneau solaire (11) est choisi dans un groupe constitué d'un panneau solaire de silicium amorphe, d'un panneau solaire de silicium monocristallin, d'un panneau solaire de polysilicium, d'un panneau solaire en couche mince et d'un panneau solaire fabriqué avec une tranche de silicium et un traitement de semi-conducteur.

4. Module photovoltaïque (1) selon la revendication 1, dans lequel le panneau solaire (11) est un panneau solaire en couche mince fait d'un matériau choisi dans un groupe constitué du silicium monocristallin, du diséléniure de cuivre et d'indium, du diséléniure de cuivre, d'indium et de gallium, du GaAs multijonction, d'un panneau solaire à colorant, et de panneaux solaires organiques/polymères.
